Europäisches Patentamt

**European Patent Office**

Office européen des brevets

(19)

(11) Publication number : **0 432 820 B1**

(12) # EUROPEAN PATENT SPECIFICATION

(45) Date of publication of patent specification :
05.04.95 Bulletin 95/14

(51) Int. Cl.[6] : **H01L 21/318,** H01L 21/203,
C30B 23/02, C30B 29/40

(21) Application number : **90203073.3**

(22) Date of filing : **20.11.90**

(54) **Laser deposition of crystalline boron nitride films.**

(30) Priority : **06.12.89 US 446758**

(43) Date of publication of application :
**19.06.91 Bulletin 91/25**

(45) Publication of the grant of the patent :
**05.04.95 Bulletin 95/14**

(84) Designated Contracting States :
**DE FR GB**

(56) References cited :
ELECTRONICS LETTERS, vol. 25, no. 23, 9th
November 1989, pages 1602-1603; T.K.PAUL
et al.: "Laser-assisted deposition of BN films
on InP for MISapplications"
THIN SOLID FILMS, vol. 153, no. 1, 26th
October 1987, pages 487-496; P. LIN etal.:
"Preparation and properties of cubic boron
nitride coatings"

(73) Proprietor : **GENERAL MOTORS**
**CORPORATION**
**General Motors Building**
**3044 West Grand Boulevard**
**Detroit Michigan 48202 (US)**

(72) Inventor : **Doll, Gary L.**
**2439 Orchard Crest**
**Utica, MI 48087 (US)**
Inventor : **Peck, Charles A.**
**915 McLean Avenue**
**Royal Oak, MI 48067 (US)**
Inventor : **Sell, Jeffrey A.**
**4348 McNay Ct. S.**
**West Bloomfield, MI 48033 (US)**

(74) Representative : **Denton, Michael John et al**
**Patent Section**
**1st Floor**
**Gideon House**
**28 Chapel Street**
**Luton Bedfordshire LU1 2SE (GB)**

EP 0 432 820 B1

Jouve, 18, rue Saint-Denis, 75001 PARIS

## Description

This invention relates to the formation of thin films of boron nitride. In particular, this invention relates to a method for forming thin films boron nitride upon a silicon substrate using a laser as specified in the preamble of claim 1, for example as disclosed in "Growth of Stoichiometric BN Films by Pulsed Laser Evaporation" Murray et al, Mat.Res.Soc. Symp. Proc., Vol.128 (1989) p469-474.

Boron nitride (BN) is a most interesting compound of Groups III-V of the Periodic Table from both the practical and scientific viewpoints. Boron nitride is characterized by three different crystal structures: hexagonal (hBN), wurtzite (wBN) and cubic zincblende (zBN). It is interesting that the physical properties of the boron nitride phase characterized by the cubic zincblende crystal structure are comparable to diamond in that the cubic zincblende crystal structure of boron nitride and diamond have low densities, extremely high thermal conductivities, and large resistivities. In addition, the cubic zincblende crystal structure of boron nitride and diamond have similar tribological properties and are relatively inert chemically.

There has been much research directed towards the growth of thin films of diamond for various purposes. Therefore significant effort has also been directed to growing films of boron nitride cubic zincblende crystal structure for the same purposes. This is not only because of the similarities between the two materials in their electrical, thermal and tribological properties, but because boron nitride of cubic zincblende crystal structure may also prove to be an attractive substrate for subsequent diamond growth due to the small mismatch in crystal lattice constants. As with the diamond films, previous attempts at depositing boron nitride films having a cubic zincblende crystal structure have failed to produce the desired homogeneous, single-crystal, and epitaxially-oriented films.

Pulsed laser deposition of thin films has recently been demonstrated to be a useful technique for preparation of thin films of a wide variety of materials including polymers, semiconductors, superconductors, and non-linear dielectric compositions. Typically, when utilizing laser deposition techniques, a substrate of appropriate material is maintained at an elevated temperature opposite to a target having a composition the same or similar to the desired thin film. A focused pulsed laser beam, usually from an excimer laser source, is incident on the target at an angle of approximately 45°. The deposition is generally performed in a vacuum or other appropriate atmosphere such as flowing oxygen in the case of copper oxide superconductors.

Advantages of the laser deposition method over other deposition techniques, such as evaporation, include a faster deposition rate, the requirement for only a single target, and the ability to deposit materials possessing high boiling-point temperatures, such as refractory materials. Advantages over sputtering deposition methods also include the requirement of only a single target, as well as the preservation of material composition from the target to the film. It is therefore advantageous to use laser deposition techniques for the formation of thin films of materials. In particular it would appear to be advantageous to use these laser deposition methods for the formation of thin films of materials such as boron nitride.

A method of forming thin films of boron nitride on a silicon substrate according to the present invention is characterised by the features specified in the characterising portion of claim 1.

In summary, it is desirable to provide thin films of cubic boron nitride, and, in particular, to provide a method for forming these thin films, wherein the resulting thin films of cubic boron nitride are essentially single-crystal, homogeneous and epitaxially oriented with the underlying substrate.

It is an object of the present invention to provide thin films of boron nitride.

It is a further object of this invention to provide a method for forming these thin films of boron nitride using laser deposition techniques.

Lastly, it is still a further object of this invention that these thin films of boron nitride be characterized by a homogeneous single crystal, cubic structure, which is epitaxially aligned with an underlying substrate.

In accordance with a preferred embodiment of this invention, these and other objects and advantages are accomplished as follows.

The applicants are the first to grow thin films of boron nitride on single-crystal silicon substrates using laser deposition techniques, wherein the films are characterized by being essentially single-crystal and having a cubic structure which is in registry with the underlying silicon substrate.

This was accomplished by first providing a single-crystal silicon substrate oriented throughout along its [100] crystallographic axis. A boron nitride target containing polycrystalline, hexagonally-oriented, pyrolytic boron nitride was located opposite from the single-crystal silicon substrate within a stainless steel 6-way cross chamber which was evacuated to a pressure of about $4 \times 10^{-2}$ Pa (about $3 \times 10^{-4}$ Torr). The n-type single crystal silicon substrate was heated to approximately 400°C and maintained there during deposition. A KrF excimer laser operating at approximately 248 nanometres and approximately 10 pulses per second was used as the ablating beam. The laser ablation of the boron nitride target was conducted in ultra high purity nitrogen gas, and at various laser fluences ranging from about 1.5 to 5.2 J/cm$^2$.

The deposited boron nitride films were examined using characterization probes of transmission electron microscopy, scanning electron microscopy, optical microscopy, and electron probe microanalysis. The boron nitride films were determined to be essentially characterized by a single-crystal, cubic structure which is in registry with the underlying silicon substrate.

Other objects and advantages of this invention will be better appreciated from the detailed description thereof, which follows.

The above and other advantages of this invention will become more apparent from the following description taken in conjunction with the accompanying drawings, in which:

Figure 1 schematically illustrates a preferred laser ablation set-up in accordance with this invention for formation of thin films of single crystal, cubic boron nitride epitaxially oriented upon a silicon substrate, and

Figure 2 is a transmission electron microscopy diffraction pattern for a representative sample of the thin films of single crystal, cubic boron nitride formed in accordance with the set-up of Figure 1.

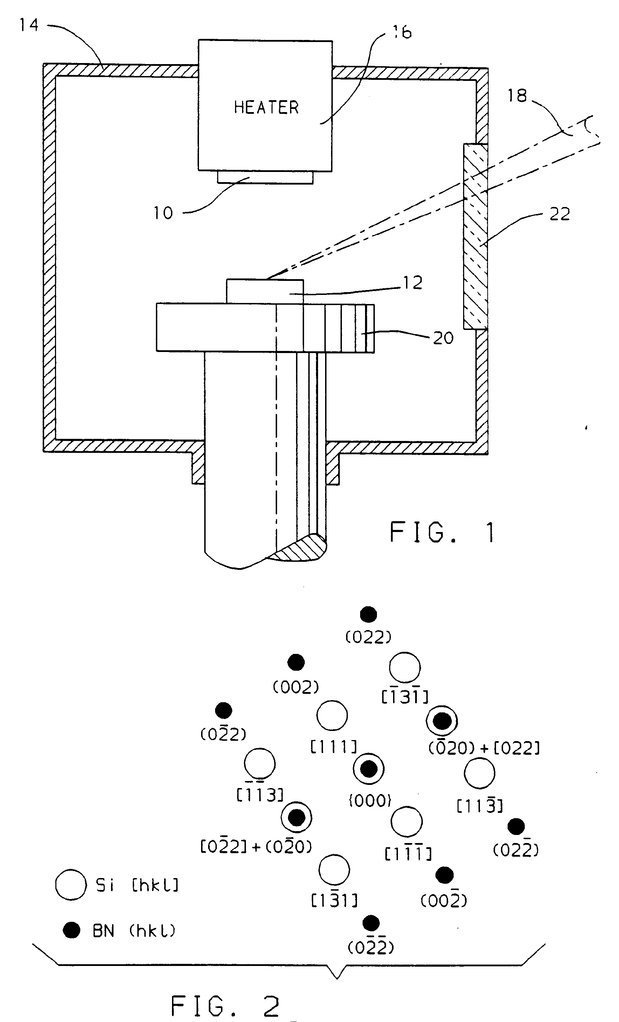

As shown schematically in accompanying Figure 1, a single-crystal silicon substrate 10 oriented throughout along its [100] crystallographic axis is provided. A boron nitride target 12 containing polycrystalline, hexagonally-oriented, pyrolytic boron nitride was provided on a rotating turntable 20 and located about 4 cm from the single-crystal silicon substrate 10 within a stainless steel 6-way cross chamber 14 which was evacuated to a pressure of about $4 \times 10^{-2}$ Pa (about $3 \times 10^{-4}$ Torr). The n-type single crystal silicon substrate 10 was heated by a heater 16 to approximately 400°C and maintained there during the ablation and deposition process. The films produced at 400°C exhibited the desired cubic, epitaxially oriented boron nitride, however there was some signs of oxygen impurities. Films have also been formed by heating the substrate to 675°C during ablation and deposition. These films exhibit significantly less impurities, however the desired cubic structure has not been confirmed. A KrF excimer laser source (the laser beam depicted as 18) operating at a wavelength of approximately 248 nanometres and a frequency of approximately 10 pulses per second was used as the ablating beam. The laser beam 18 emitted from the excimer laser source outside the chamber 14, passed through a transparent window 22 prior to incidence upon the target 12. The depositions were conducted in ultra high purity nitrogen gas and at various laser fluences ranging from about 1.5 to 5.2 J/cm².

More specifically, prior to the laser deposition, a polished n-type, single crystal, silicon wafer oriented along its [100] crystallographic axis was provided. The wafer had a thin, naturally-occurring oxide layer on its surface believed to be of the order of several nanometres thick. The wafer was cut into approximately 1 square centimetre pieces, ultrasonically cleaned and fastened to a substrate holder. The silicon substrate was attached to the heater within the chamber and heated to approximately 400°C. This temperature was maintained during the deposition.

The laser depositions were performed in a stainless steel 6-way cross chamber which was evacuated by a turbomolecular pump to approximately $4 \times 10^{-2}$ Pa ($3 \times 10^{-4}$ Torr) pressure. The target, a piece of polycrystalline, highly-oriented, hexagonal boron nitride commercially available from Union Carbide, was rotated during the laser ablation to prevent excessive cratering within the target from the laser/target interaction. Unoriented, hexagonal BN targets (Union Carbide commercial grades HBC or HBR) may also be used. A KrF excimer laser operating at a wavelength of approximately 248 nanometres and a frequency of approximately 10 pulses per second, was used as the ablating beam. The target to substrate separation was approximately 4 centimetres, but may vary between about 2.5 centimetres and greater than 4 centimetres depending upon the operating parameters of the laser.

The laser ablations of the boron nitride target were conducted within the evacuated chamber in the presence of ultra high purity, i.e., approximately 99.99995%, nitrogen gas flowing at 10 sccm. For the present chamber geometry, this resulted in an ambient pressure of approximately 6 Pa (45 mTorr) at the deposition surface of the silicon substrate. The presence of the nitrogen gas served to limit the size of the plasma plume generated by the interaction between the laser and the target, and to make the nitrogen concentration of the films nearly stoichiometric with the boron. The applicants have also deposited boron nitride films in $NH_3$ gas using the method of the present invention, to try to increase the nitrogen content. The applicants believe the films obtained were also cubic, epitaxial boron nitride. After the deposition of the boron nitride onto the silicon substrate, the film and substrate were cooled in flowing nitrogen to room temperature.

The laser depositions of boron nitride were conducted at various laser fluences ranging from approximately 1.5 to 5.2 J/cm². In a separate experiment, the minimum threshold fluence for ablation of the hexagonal boron nitride target was determined to be approximately 0.31 to 0.34 J/cm². Therefore, the laser depositions occurred at fluences significantly greater than the minimum threshold required.

The thickness of the boron nitride thin films as determined by stylus profilometry, were found to vary linearly with laser fluence. The thickness was also found to be linearly dependent on the number of laser pulses. At a laser fluence of approximately 3.9 J/cm², an average deposition rate of approximately 0.0182 nanometres per pulse was measured. For a 12,000 pulse run and a laser fluence of approximately 1.5 J/cm² a film was produced having a thickness of approximately 176 nanometres.

In the films deposited in accordance with this invention, it was observed that the boron nitride/silicon interface had a blue appearance. This indicates that the films form an anti-reflective coating absorbing in the yellow-green region of the visible spectrum. The film thickness (d), index of refraction (n), and absorbed wavelength ($\lambda$) are related to each other for anti-reflective coatings, through the equation

$$nd = (m - 1/2) \times (\lambda/2)$$

where m is the interference order integer. For $\lambda$ equal to 550 nanometres (yellow-green light), and a film thickness, d, equal to approximately 176 nanometres, it is found that n is equal to (m - 1/2) x 1.56. Clearly m equal to 1 is not the interference order since n can never be less than unity. However, with m equal to 2, n is equal to approximately 2.34, which is consistent with that of cubic boron nitride at 2.1 and that of diamond at 2.42.

The film morphology was investigated with optical and scanning electron microscopic techniques. To the resolution limit of the scanning electron microscopy instrument, approximately 10 nanometres, no evidence of grain boundaries was observed. This implies that either the film is a single crystal, or that the film is amorphous possessing little or no crystallinity. The latter hypothesis was excluded as a result of subsequent transmission electron microscopy research. The optical microscope provided evidence that the film was of uniform thickness and nearly transparent. Micrometresized particulates of undetermined origin were also observed to be sparsely distributed across the film surface, however, it is believed that these particulates can be eliminated with further development and testing of the operating parameters.

The relative atomic composition of the boron nitride thin films prepared in accordance with this invention were determined with electron probe microanalysis employing the ZAF analytical technique. It was found that the resulting film is slightly non-stoichiometric with approximately 57% boron and 41% nitrogen, and with a plus or minus 10% relative error. In addition, trace impurities of carbon and oxygen, less than approximately 1% of each, were observed.

The combination of low X-ray scattering intensities for boron nitride and a 176 nm film thickness makes characterization using conventional X-ray diffraction difficult. However, initial patterns on the resulting thin films of boron nitride showed indications of a crystalline cubic phase. This finding was confirmed through transmission electron microscopy, which is especially well-suited to the aforementioned problems. It was determined that the resulting thin films were characterized by a cubic structure. It is believed that the impingement of the laser on the hexagonally-oriented boron nitride target results in dissociation of the boron nitride compound, thereby permitting the vaporized boron and nitrogen atoms to deposit on and align themselves with the cubic silicon substrate.

In order to use transmission electron microscopy, the substrates had to be slowly etched in order to obtain boron nitride films having a thickness of approximately 5 to 10 nanometres. A dilute acid etch comprising hydrofluoric acid and nitric acid in water was used to reduce the thickness of the silicon to less than 1 micrometre. The boron nitride/silicon substrate was then ion-milled thereby producing regions of extremely thin boron nitride.

The transmission electron microscopy diffraction pattern of a representative region showed a diffraction pattern of a cubic crystal with a lattice constant of approximately 0.38 nanometres (3.8 Angstroms). However the accepted lattice constant of cubic zincblende boron nitride powder is approximately 0.36 nanometres (3.6 Angstroms). Thus the thin film lattice for the cubic boron nitride formed in accordance with this invention is expanded by about 5% from the accepted cubic zincblende boron nitride powder lattice. The 0.38 nanometres (3.8 Angstrom) lattice constant of the boron nitride film of the invention closely resembles a dense, cubic form of boron nitride called "shock-wave compressed".

As shown in Figure 2, the transmission electron microscopy diffraction patterns for the resulting cubic boron nitride films formed upon the silicon substrate contain a superposition of a [211] plane of silicon and a (100) plane of cubic boron nitride. This diffraction pattern shows that the [022] direction of silicon is parallel to the (020) direction of the cubic boron nitride films, and that the [111] direction of silicon is almost parallel to the (002) direction of cubic boron nitride. Therefore, there is a preferred orientation for the cubic boron nitride films with respect to the underlying silicon substrate, with the (020) direction of cubic boron nitride parallel to the [022] direction of silicon. This is considered to be substantial evidence that the cubic boron nitride film is epitaxially aligned with the silicon substrate.

The 0.38 nanometre (3.8 Angstrom) lattice constant of the cubic boron nitride film is particularly well-suited to the silicon substrate. Since silicon has a diamond-like crystallographic structure with a lattice constant of approximately 0.542 nanometres (5.42 Angstroms), two cubic boron nitride lattice constants can fit across the [100] diagonal of the silicon lattice, i.e., 0.38 nanometres equals 0.542 nanometres divided by $2^{1/2}$. In this configuration, either the boron or the nitrogen atoms will reside over the silicon atoms.

The applicants have also deposited, using this method of the invention, boron nitride on single crystal silicon substrates oriented along the [110] crystallographic plane and believe that the transmission electron microscopy results will show cubic, epitaxial boron nitride. The applicants have deposited boron nitride on single crystal silicon oriented along the [111] plane and this results in hexagonally-oriented boron nitride. Cubic, epitaxially-aligned silicon has also been obtained by the method of the present invention using 193 nanometre radiation from an ArF excimer laser at the same fluences described above, but at a photon energy of about 6.2 electron volts.

In general, for every known and potential application considered for diamond films, cubic boron nitride may be an appropriate substitute. Since cubic boron nitride is an excellent insulator which can be grown epitaxially on silicon and presumably has a high thermal conductivity similar to the cubic zincblende crystal structure of boron nitride, cubic boron nitride will have numerous uses as an insulating, thermally-conductive barrier layer for silicon-based microelectronic devices. Further, the cubic boron nitride should be appropriate for many wear-resistant applications, since the cubic zincblende crystal structure of boron nitride is second in hardness only to diamond.

This invention readily provides a method for forming single-crystal, epitaxially-aligned thin films of cubic boron nitride on single-crystal silicon substrates.

## Claims

1. A method for forming thin films of boron nitride on a silicon substrate (10) in a vacuum by inducing vaporization of a boron nitride target (12) disposed in proximity with said silicon substrate (10), using a laser (18), <u>characterised in that the</u> method comprises the following steps: providing said silicon substrate (10) in the form of a silicon substrate oriented essentially throughout along its [100] crystallographic axis, and heating said substrate to approximately 400°C; providing said boron target (12) in the form of a boron nitride target comprised essentially of polycrystalline hexagonally-oriented pyrolytic boron nitride; and inducing said vaporization of said boron nitride target (12) by said laser (18) wherein said vaporized boron nitride deposits onto a surface of said silicon substrate (10) to form a thin film layer of boron nitride on said silicon surface, said thin film layer of boron nitride being characterized by a single crystal, cubic structure crystallographically aligned with said silicon substrate (10).

2. A method for forming thin films of boron nitride according to claim 1, <u>characterised in that</u> said laser (18) is a KrF excimer laser source which operates at a wavelength of approximately 248 nanometres.

3. A thin film of boron nitride on a silicon substrate (10), where said silicon substrate (10) is oriented essentially along its [100] crystallographic plane, and said thin film of boron nitride is essentially a cubic single crystal structure crystallographically oriented with said silicon substrate (10).

## Patentansprüche

1. Ein Verfahren zum Bilden dünner Filme aus Bornitrid auf einem Siliziumsubstrat (10) in einem Vakuum, indem eine Verdampfung eines Bornitrid-Ziels (12), das in der Nähe des Siliziumsubstrats (10) angeordnet ist, herbeigeführt wird, wobei ein Laser (18) verwendet wird, <u>dadurch gekennzeichnet, daß</u> das Verfahren die folgenden Schritte enthält, daß: das Siliziumsubstrat (10) in der Form eines Siliziumsubstrats vorgesehen wird, das im wesentlichen durchweg entlang seiner [100]-Kristallachse orientiert ist, und das Substrat auf annähernd 400°C erhitzt wird; das Borziel (12) in der Form eines Bornitrid-Ziels vorgesehen wird, das im wesentlichen aus polykristallinem, hexagonal orientiertem pyrolytischem Bornitrid besteht; und die Verdampfung des Bornitrid-Ziels (12) durch den Laser (18) herbeigeführt wird, worin sich das verdampfte Bornitrid auf eine Oberfläche des Siliziumsubstrats (10) ablagert, um eine dünne Filmschicht aus Bornitrid auf der Siliziumoberfläche zu bilden wobei die dünne Filmschicht aus Bornitrid durch eine einkristalline kubische Struktur gekennzeichnet ist, die mit dem Siliziumsubstrat (10) kristallographisch ausgerichtet ist.

2. Ein Verfahren zum Bilden dünner Filme aus Bornitrid nach Anspruch 1. <u>dadurch gekennzeichnet, daß</u> der Laser (18) eine KrF-Excimerlaserquelle ist, die bei einer Wellenlänge von annähernd 248 Nanometer arbeitet.

3. Ein dünner Film aus Bornitrid auf einem Siliziumsubstrat (10), wo das Siliziumsubstrat (10) im wesentlichen entlang seiner [100]-Kristallsymmetrieebene orientiert ist und der dünne Film aus Bornitrid im wesentlichen eine kubische Einkristall-Struktur ist, die mit dem Siliziumsubstrat (10) kristallographisch orientiert ist.

## Revendications

1. Procédé pour former des films minces de nitrure de bore sur un substrat de silicium (10) sous vide en induisant la vaporisation d'une cible de nitrure de bore (12) disposée à proximité dudit substrat de silicium (10), utilisant un laser (18), caractérisé en ce que le procédé comporte les étapes suivantes: préparer ledit substrat de silicium (10) sous la forme d'un substrat de silicium orienté essentiellement de bout en bout suivant son axe cristallographique [100], et chauffer ledit substrat à environ 400°C; préparer ladite cible de nitrure de bore (12) sous la forme d'une cible de nitrure de bore composée essentiellement de nitrure de bore pyrolytique polycristallin à orientation hexagonale; et induire ladite vaporisation de ladite cible de nitrure de bore (12) à l'aide dudit laser (18), suivant lequel ledit nitrure de bore vaporisé se dépose sur une surface dudit substrat de silicium (10) pour former une couche de film mince de nitrure de bore sur ladite surface de silicium, ladite couche de film mince de nitrure de bore étant caractérisée par une structure monocristalline cubique alignée cristallographiquement avec ledit substrat de silicium (10).

2. Procédé pour former des films minces de nitrure de bore selon la revendication 1, caractérisé en ce que ledit laser (18) est une source de laser excimère de KrF qui fonctionne à une longueur d'onde d'environ 248 nanomètres.

3. Film mince de nitrure de bore sur un substrat de silicium (10) où ledit substrat de silicium (10) est orienté essentiellement suivant son plan cristallographique [100], et ledit film mince de nitrure de bore est essentiellement une structure monocristalline cubique orientée cristallographiquement avec ledit substrat de silicium (10).

FIG. 1

FIG. 2